# FASCICULE DE BREVET EUROPEEN

(11) **EP 0 851 465 B1**
(45) Date de publication et mention de la délivrance du brevet: **09.09.2009**
(21) Numéro de dépôt: 97402947.2
(22) Date de dépôt: 05.12.1997
(51) Int. Cl.: H01L 21/20, H01L 21/265, H01L 21/762

(54) **Procédé de séparation d'au moins deux éléments d'une structure en contact entre eux par implantation ionique**
Verfahren zum Trennen von mindestens zwei Elementen einer Struktur, die durch Ionenimplantation verbunden sind
Method of separation of at least two elements joined by ion implantation

(30) Priorité: 09.12.1996 FR 9615089
(43) Date de publication de la demande: 01.07.1998
(73) Titulaire: COMMISSARIAT A L'ENERGIE ATOMIQUE, 75015 Paris (FR)
(72) Inventeur: Bruel, Michel, 38113 Veurey (FR); Di Cioccio, Léa, 38330 Saint-Ismier (FR)
(74) Mandataire: Poulin, Gérard

(56) Documents cités:
- GB-A- 2 211 991
- US-A- 5 374 564
- US-A- 5 559 043
- BRUEL M ET AL: ""SMART CUT": A PROMISING NEW SOI MATERIAL TECHNOLOGY" 1995 IEEE INTERNATIONAL SOI CONFERENCE PROCEEDINGS, TUCSON, OCT. 3 - 5, 1995, 3 octobre 1995, INSTITUTE OF ELECTRICAL AND ELECTRONICS ENGINEERS, page 178/179 XP000590656
- DI CIOCCIO L. ET AL: 'Silicon carbide on insulator formation using the Smart Cut process' ELECTRONICS LETTERS vol. 32, no. 12, 06 Juin 1996, UK, pages 1144 - 1145
- ASPAR B. ET AL: 'Transfer of structured and patterned thin silicon films using the Smart-Cut(R) process' ELECTRONICS LETTERS vol. 32, no. 21, 10 Octobre 1996, UK, pages 1985 - 1986, XP006005812

## Description

La présente invention concerne un procédé de séparation d'au moins deux éléments d'une structure, ces deux éléments étant en contact entre eux selon une interface et étant fixés l'un à l'autre par des liaisons interatomiques au niveau de cette interface. Les deux éléments de la structure sont constitués de matériaux solides qui sont de natures différentes. Il peut s'agir de matériaux conducteurs, semiconducteurs ou diélectriques.

Selon une première utilisation de l'invention, ce procédé permet une séparation complète des deux éléments de la structure. Selon une deuxième utilisation de l'invention, ce procédé permet une séparation localisée des deux éléments pour obtenir par exemple des micro-coussinets pressurisés par une phase gazeuse.

La séparation de deux éléments liés entre eux par des liaisons interatomiques n'est pas facile à obtenir surtout pour des éléments de très petites dimensions comme c'est le cas dans le domaine de la microélectronique. Cette opération est encore plus délicate lorsque l'on désire obtenir une séparation localisée des deux éléments. Une telle séparation localisée, lorsqu'elle est envisagée entre deux couches d'une structure microélectronique permettrait de réaliser des micro-coussinets pressurisés par introduction d'un gaz entre les parties séparées des deux couches.

L'obtention de tels micro-coussinets pressurisés dans des dispositifs relevant de la microélectronique semble particulièrement difficile à obtenir par des procédés classiques. En effet, la plupart des procédés microélectroniques se déroulent dans des machines à basse pression ou à pression atmosphérique. Dans ces conditions, si on peut introduire une phase gazeuse à une pression déterminée dans une micro-cavité réalisée dans une structure en établissant une communication physique avec un milieu contenant le gaz correspondant à une pression désirée, il est difficile, voire impossible, de fermer la micro-cavité en gardant la phase gazeuse à la pression voulue.

Le document US 5 559 043 divulgue un procédé de dépôt de lames semiconductrices sur un support. Le procédé comprend le bombardement ionique d'une face d'un substrat pour créer une couche de microcavités à une profondeur déterminée la solidarisation de la face bombardée sur le support, l'application d'un traitement thermique aux microcavités correspondant à une lame à détacher pour provoquer leur coalescence, la désolidarisation du substrat par rapport au support qui conserve la lame détachée du substrat.

L'article « Silicon carbide on insulator formation using the Smart Cut process », L. Di Cioccio et al., Electronics letters, U.K., 6 juin 1996, Vol. 32, N° 12, pages 1144 à 1145, divulgue un procédé de realisation d'une structure SiCOI comprenant des étapes d'implantation d'ions hydrogène dans un premier substrat, de fixation de la face implantée du premier substrat sur un deuxième substrat, de traitement thermique provoquant le clivage du premier substrat et enfin de polissage de la surface clivée.

Les inventeurs de la présente invention ont découvert qu'il est possible d'introduire une phase gazeuse à l'interface entre deux couches en contact sans avoir besoin de réaliser une communication physique entre cette interface et l'extérieur. Ils ont découvert que, par implantation d'ions d'un gaz approprié, il est possible d'obtenir une cassure des liaisons interatomiques existant entre les atomes des couches situées de part et d'autre de l'interface et même d'obtenir, si la dose d'ions implantés est suffisamment importante, la présence d'une phase gazeuse dans la zone de l'interface qui a été implantée. Si la dose d'ions implantée est correctement ajustée, la phase gazeuse introduite possède une pression suffisante pour obtenir le décollement des deux couches et fournir un micro-coussinet pressurisé. Par traitement de la totalité de l'interface, on peut obtenir une séparation complète des deux couches.

L'invention a donc pour objet un procédé de séparation selon la revendication 1.

La dose d'ions implantés peut être telle qu'elle provoque, au niveau de ladite interface, la constitution d'une phase gazeuse possédant une pression suffisante pour permettre la séparation des deux éléments.

Le procédé peut être décomposé en une étape d'implantation ionique proprement dite, suivie éventuellement d'une étape de traitement thermique permettant de concentrer les ions implantés au niveau de ladite interface.

Par exemple, si la structure est une structure semiconductrice du type silicium sur isolant, une couche de silicium constituant l'un des deux éléments de la structure et une couche d'oxyde de silicium constituant l'autre élément de la structure, les ions implantés peuvent être des ions d'hydrogène.

L'implantation ionique peut être effectuée sur la totalité de ladite interface de façon à obtenir une séparation complète des deux éléments de la structure.

Elle peut aussi être effectuée sur au moins une zone de ladite interface de façon à obtenir une séparation des deux éléments de la structure dans cette zone. Dans ce cas, l'implantation ionique peut être effectuée selon une dose permettant de conférer à la phase gazeuse constituée dans ladite zone une pression suffisante pour déformer au moins l'un des deux éléments de la structure. De préférence, la forme de ladite zone implantée est telle que la déformation dudit élément de la structure constitue un bossage ou un coussinet. La face externe de l'élément déformé par la pression de la phase gazeuse peut être rendue conductrice (par exemple par le dépôt d'une couche métallique), la structure pouvant ainsi présenter un contact électrique souple à un élément extérieur. Le procédé peut aussi prévoir la formation d'électrodes positionnées de façon à former au moins un condensateur où ladite phase gazeuse intervient comme diélectrique.

Selon ce dernier aspect de l'invention, le procédé peut être utilisé pour obtenir un capteur de pression par mesure de la capacité du condensateur. Il peut aussi être utilisé pour obtenir une matrice de capteurs de pression par mesure des capacités correspondant aux condensateurs formés à partir d'une matrice de zones implantées.

Le procédé selon la présente invention peut aussi être utilisé pour obtenir une masse de SiC recouverte d'une couche de SiO₂, ladite structure étant constituée d'un premier élément en silicium et d'un deuxième élément en SiO₂ obtenu par croissance thermique à partir du premier élément, le deuxième élément étant solidarisé à la masse de SiC avant de provoquer la séparation entre le premier et le deuxième élément.

L'invention sera mieux comprise et d'autres avantages et particularités apparaîtront à la lecture de la description qui va suivre, donnée à titre d'exemple non limitatif, accompagnée des dessins annexés parmi lesquels :
- la figure 1 est un diagramme illustrant le profil de concentration d'ions implantés dans un matériau ;
- la figure 2 illustre l'application du procédé selon l'invention en vue d'obtenir la séparation de deux couches adhérant l'une à l'autre selon une interface ;
- la figure 3 est une vue de dessus d'une matrice de capteurs de pression réalisée en appliquant le procédé de l'invention ;
- la figure 4 est une vue de côté et en coupe selon l'axe IV-IV de la matrice de capteurs de pression représentée à la figure 3 ;
- la figure 5 est une vue de côté et en coupe d'une structure présentant un contact électrique souple obtenue en appliquant le procédé selon l'invention ;
- les figures 6A et 6B illustrent une application particulière du procédé selon la présente invention.

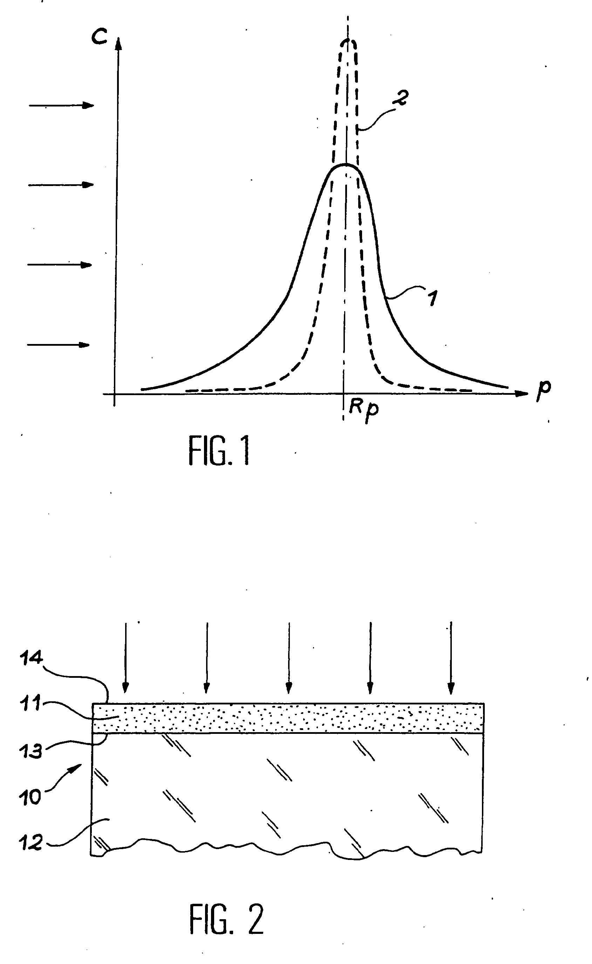

Lorsque l'on bombarde une plaquette d'un matériau solide par des ions, ceux-ci pénètrent plus ou moins profondément dans la plaquette en fonction de l'énergie qui leur est donnée et en fonction de la nature du matériau. En considérant que la plaquette est réalisée en un matériau homogène, qu'elle possède une face plane et que le bombardement ionique est réalisé par un faisceau d'ions possédant une énergie déterminée, les ions implantés dans la plaquette vont se répartir autour d'une profondeur moyenne avec une concentration maximum autour de cette profondeur moyenne. La figure 1 montre un exemple d'un profil de concentration ionique correspondant à l'implantation d'ions H⁺ (protons) dans une plaquette de silicium monocristallin. Pour plus de détail on pourra se reporter au document FR-A-2 681 472 décrivant un "Procédé de fabrication de films minces de matériau semiconducteur".

Sur la figure 1, l'axe des ordonnées correspond à la face plane de la plaquette par laquelle pénètre un faisceau d'ions d'énergie déterminée et symbolisé par des flèches. L'axe des abscisses, parallèle à la direction du faisceau d'ions, représente la profondeur p de la plaquette. La courbe 1 représente le profil de concentration C des ions implantés, l'implantation ayant été réalisée à une température déterminée, par exemple à température ambiante. La courbe 1 montre que la concentration d'ions implantés est maximale pour la profondeur Rp. Il est donc possible de concentrer une quantité relativement important d'ions à une profondeur déterminée à l'intérieur d'un élément solide.

Selon la présente invention, on utilise cette technique pour réaliser la séparation de deux éléments reliées l'un à l'autre, selon une interface, par des liaisons interatomiques. Le principe de l'invention consiste à introduire des ions à l'interface des deux éléments, ces ions étant aptes à casser les liaisons interatomiques existant entre les deux éléments. Ces ions sont introduits à l'interface selon une dose déterminée qui est suffisante pour provoquer la séparation des deux éléments. Cela signifie que la séparation peut intervenir parce qu'il y a suffisamment de liaisons interatomiques qui sont cassées et parce que l'implantation peut provoquer en outre, suivant la dose, la formation d'une phase gazeuse au niveau de l'interface possédant une pression qui peut contribuer à la séparation des deux éléments. Cette séparation peut intervenir naturellement, c'est-à-dire sans effort exercé sur les éléments. La séparation peut aussi intervenir en exerçant un effort, par exemple en appliquant une force mécanique, sur les éléments.

Par souci d'efficacité, il est avantageux que la concentration maximale d'ions implantés coïncide avec l'interface entre les deux éléments à séparer. Pour cela, il suffit de calculer les paramètres d'implantation en fonction de la nature du ou des matériaux constituant les éléments à séparer et en fonction de la nature des ions.

L'efficacité du procédé peut être encore améliorée si on procède, après l'étape d'implantation ionique, à un traitement thermique approprié. Un tel traitement thermique permet, dans certains cas, de redistribuer le profil de concentration des atomes implantés pour obtenir un profil de concentration plus étroit et de sommet plus élevé. On peut alors obtenir un profil correspondant à la courbe 2 pour l'exemple illustré par la figure 1.

La figure 2 illustre l'application du procédé à la séparation complète de deux éléments 11 et 12 constituant une structure 10 et fixés entre eux par des liaisons interatomiques selon leur interface 13. A titre d'exemple, on supposera que l'élément 11 est une couche de silice SiO₂ de 1 µm d'épaisseur obtenue par dépôt de type CVD à basse pression sur l'élément 12 qui est un substrat de silicium monocristallin. Les ions implantés, au travers de la face 14 de la couche 11 parallèle à l'interface 13, sont des ions H⁺. La dose d'implantation est de 5.10¹⁶ ions par cm² et l'énergie des ions est comprise entre 100 et 140 keV. Un traitement thermique, postérieur à l'étape d'implantation, peut être effectué à 500°C pendant 30 minutes. Les ions implantés modifient les liaisons interatomiques existant entre les atomes des éléments situés de part et d'autre de l'interface. Dans le cas présent d'une interface Si-SiO₂, l'introduction d'hydrogène permet de casser les liaisons Si-O-Si en les transformant en liaisons Si-O-H et Si-H.

Un autre exemple d'application concerne la séparation de couches minces dans un substrat du type silicium-sur-isolant. Il est possible, grâce au procédé selon l'invention, de séparer la couche superficielle de silicium du substrat, ou l'ensemble constitué par la couche superficielle de silicium et la couche d'isolant enterré du reste du substrat. Il suffit d'implanter des ions d'hydrogène soit à l'interface couche mince de silicium-couche d'isolant si l'on veut récupérer la couche de silicium, soit à l'interface couche d'isolant-silicium massif si l'on veut récupérer l'ensemble constitué par la couche mince de silicium et la couche d'isolant.

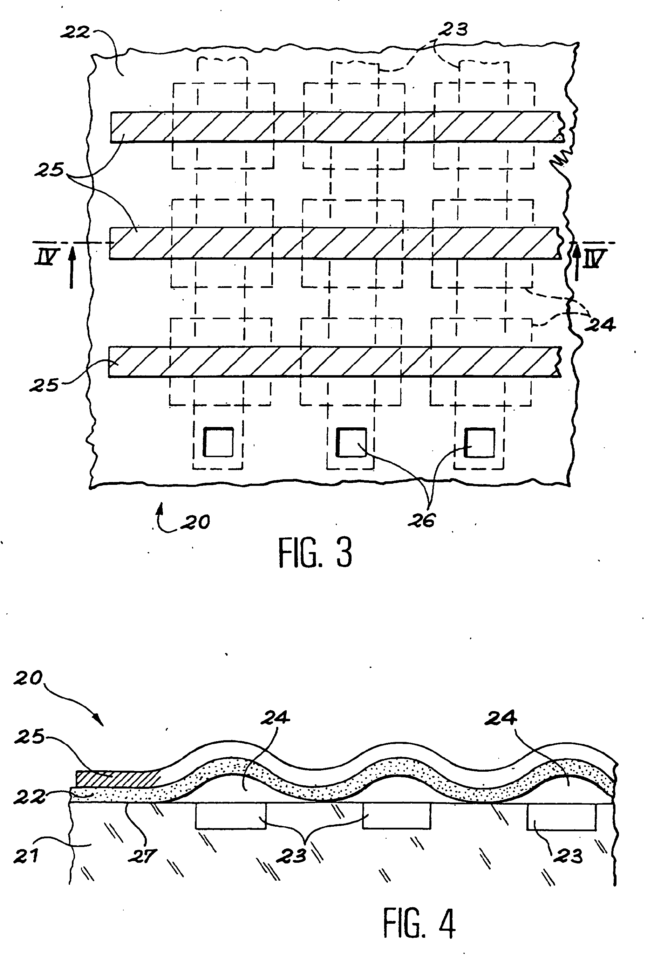

Les figures 3 et 4 illustrent une application du procédé pour obtenir des séparations localisées de deux éléments. Ces figures concernent la réalisation d'une matrice de capteurs de pression 20. La structure de départ comprend un substrat 21 en silicium monocristallin dopé n sur lequel on a fait croître une couche 22 d'oxyde thermique. La couche 22 et le substrat 21 présentent donc une interface 27. Le substrat 21 présente des caissons 23, en forme de bandes parallèles, dopés p⁺ pour les rendre conducteurs.

L'obtention de séparations localisées entre la couche 22 et le substrat 21 se fait de la manière suivante. Par masquage lithographique, on dégage des ouvertures correspondant à la surface des zones à implanter. On effectue ensuite une implantation ionique d'hydrogène selon une dose et une énergie déterminées de façon que ces ions atteignent majoritairement l'interface entre la couche 22 et le substrat 21, au travers des ouvertures du masque déposé sur la couche 22. Ailleurs, le masque empêche les ions d'atteindre l'interface. La dose d'ions implantés est également suffisante pour induire la constitution d'une phase gazeuse dans les zones d'interface concernées. Le masque est alors retiré. On peut ainsi obtenir une matrice de coussinets pressurisés 24 correspondant à une matrice d'ouvertures dans le masque. Ces coussinets 24 sont disposés au-dessus des caissons 23. Eventuellement, le procédé peut impliquer une étape de traitement thermique pour concentrer les ions implantés à l'interface.

On dépose ensuite, sur la couche d'oxyde 22, des électrodes 25 constituées de bandes parallèles entre elles mais perpendiculaires aux caissons 23 en forme de bandes également et passant sur les coussinets pressurisés. Le dépôt de plots 26, après gravure de la couche d'oxyde, permet d'assurer la connexion électrique avec les caissons 23. Les électrodes 25 et les plots 26 peuvent être en aluminium et déposés au cours d'une même étape.

A titre de variante, le dépôt des électrodes 25 et des plots 26 peut être réalisé avant l'opération d'implantation ionique. L'implantation ionique est alors réalisée ultérieuremenet, avec une énergie suffisante pour traverser les électrodes 25 et la couche d'oxyde 22.

On a ainsi réalisé une matrice de capteurs de pression du type capacitif. Chaque capteur de pression est constitué par le condensateur élémentaire situé à l'emplacement du croisement d'une électrode 25 et d'une électrode 23 (ou caisson conducteur), entre lesquelles se trouve un coussinet pressurisé 24.

La matrice de capteurs de pression obtenue comprend donc des lignes (par exemple les électrodes métalliques 25) et des colonnes (par exemple les caissons conducteurs 23). La pression dans un élément (i, j) de la matrice de capteurs, correspondant au croisement d'une ligne i et d'une colonne j, est obtenue par mesure de la capacité de l'élément (i, j). Pour cela, toutes les lignes, sauf la ligne i, et toutes les colonnes, sauf la colonne j, sont mises en haute impédance. On mesure alors la capacité existant entre la ligne i et la colonne j.

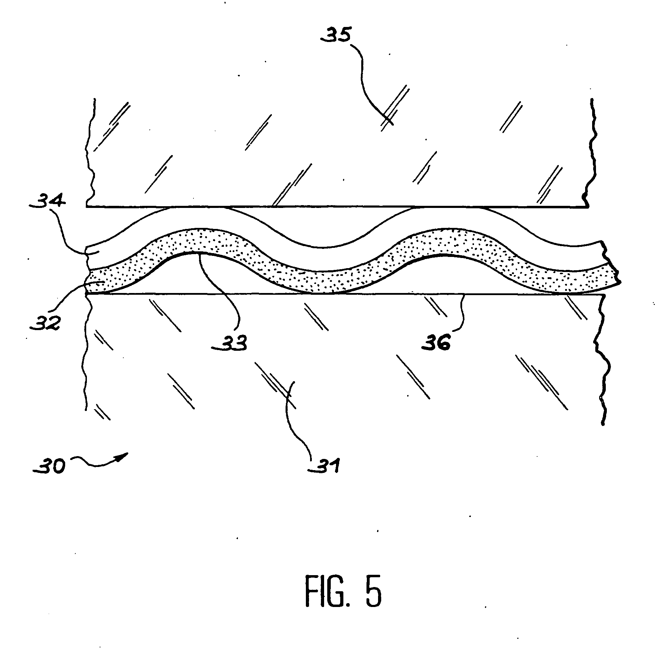

D'une façon similaire, on peut réaliser une structure présentant un contact électrique souple à un élément extérieur. C'est ce que montre la figure 5 où la structure 30 de départ est constituée d'un substrat 31 en silicium monocristallin recouvert d'une couche d'oxyde thermique 32. La couche 32 et le substrat 31 présentent donc une interface 36. Par implantation ionique, suivie éventuellement d'une étape de traitement thermique, on peut décoller certaines zones de la couche 32 du substrat 31 pour obtenir des bossages 33 de la forme désirée. La couche d'oxyde 32 est recouverte d'une couche métallique 34. La structure 30 permet alors d'assurer un contact électrique souple avec un élément extérieur 35.

Un autre exemple d'application concerne le transfert d'une couche disposée sur un substrat initial vers un substrat cible. Le procédé selon l'invention s'avère alors particulièrement intéressant pour obtenir une couche d'oxyde thermique de bonne qualité sur un substrat cible notamment en SiC. En effet, la croissance thermique directe d'oxyde sur un substrat de SiC donne un oxyde de mauvaise qualité. Selon l'invention une couche d'oxyde de bonne qualité peut être produite sur un substrat initial en silicium et être transférée sur un substrat cible en SiC. Le procédé peut être conduit de la manière suivante.

Le substrat cible est par exemple constitué d'une plaquette de SiC recouverte d'une couche épitaxiée de SiC pour obtenir un carbure de silicium de qualité satisfaisante. Le substrat initial est constitué d'une plaquette de silicium sur laquelle on a fait croître une couche d'oxyde thermique. Conformément à l'invention, des ions, par exemple des ions hydrogène, sont implantés à l'interface située entre la couche d'oxyde et la masse de silicium du substrat initial. La dose des ions implantés est choisie de façon à ne pas obtenir une séparation immédiate de la couche d'oxyde, mais de façon que cette séparation puisse se faire postérieurement grâce à un traitement thermique approprié.

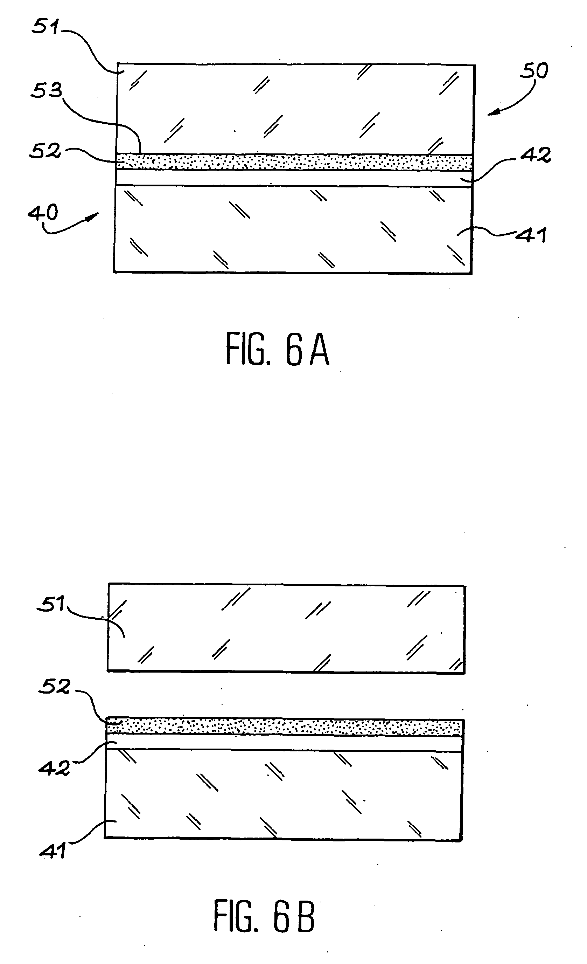

Les deux substrats sont mis en contact, la couche d'oxyde thermique étant adjacente à la couche de SiC épitaxiée, après que les surfaces destinées à être mises en contact aient reçu une préparation appropriée (nettoyage, polissage). Cette préparation de surface permet un collage des deux couches par adhérence moléculaire. On obtient l'assemblage représenté à la figure 6A où le substrat cible 40 est constitué d'une plaquette de SiC 41 recouverte d'une couche épitaxiée 42 et où le substrat initial 50 est constitué d'une plaquette de silicium 51 recouverte d'une couche d'oxyde thermique 52. On a représenté sous la référence 53 l'interface entre la plaquette 51 et la couche 52, cette interface ayant subi l'implantation ionique.

L'ensemble peut alors être soumis à un traitement thermique facultatif, à une température T₁ relativement basse, destinée à renforcer les liaisons interatomiques entre les couches 42 et 52 de manière à augmenter leur adhérence.

On procède ensuite à la séparation en deux parties de l'ensemble ainsi constitué, au niveau de l'interface 53 conformément à la présente invention. Cette séparation est par exemple obtenue par un traitement thermique effectué à une température T₂>T₁. Le résultat obtenu est représenté à la figure 6B.

On peut ensuite procéder à des opérations complémentaires : une opération de finition de surface de la face libre de la couche d'oxyde 52 (par exemple par polissage, par gravure) et une opération de stabilisation du collage des couches 42 et 52 par un traitement thermique à une température T₃>T₂.

Bien que les exemples décrits ci-dessus concernent une structure dont les principaux éléments constitutifs sont en silicium et en oxyde de silicium, le procédé selon la présente invention peut s'appliquer à tout matériau solide pourvu que l'épaisseur des éléments permettent d'implanter de manière appropriée des ions à une interface considérée.

## Revendications

1. Procédé de séparation d'au moins deux éléments (11, 12 ; 21, 22 ; 31, 32) de natures différentes, d'une structure, les deux éléments étant en contact entre eux selon une interface (13, 27, 36) et fixés l'un à l'autre par des liaisons interatomiques au niveau de cette interface,
qui comporte :
une implantation ionique pour introduire des ions dans la structure (10, 20, 30) avec une énergie suffisante pour qu'ils atteignent ladite interface (13, 27, 36) et selon une dose suffisante pour casser lesdites liaisons interatomiques et permettre une séparation des deux éléments (11, 12 ; 21, 22 ; 31, 32).

2. Procédé de séparation selon la revendication 1, la dose d'ions implantés provoquant, au niveau de ladite interface, la constitution d'une phase gazeuse possédant une pression suffisante pour permettre la séparation des deux éléments.

3. Procédé de séparation selon l'une des revendications 1 ou 2, l'étape d'implantation ionique étant suivie d'une étape de traitement thermique permettant de concentrer les ions implantés au niveau de ladite interface (13, 27, 36).

4. Procédé de séparation selon l'une quelconque des revendications 1 à 3, ladite structure (10, 20, 30) étant une structure semiconductrice du type silicium sur isolant, une couche de silicium (12, 21, 31) constituant l'un des deux éléments de la structure et une couche d'oxyde de silicium (11, 22, 32) constituant l'autre élément de la structure, les ions implantés étant des ions d'hydrogène.

5. Procédé selon l'une quelconque des revendications 1 à 4, l'implantation ionique étant effectuée sur la totalité de ladite interface (13) de façon à obtenir une séparation complète des deux éléments (11, 12) de la structure (10).

6. Procédé selon l'une quelconque des revendications 1 à 4, l'implantation ionique étant effectuée sur au moins une zone de ladite interface (27, 36) de façon à obtenir une séparation des deux éléments (21, 22 ; 31, 32) de la structure (20, 30) dans cette zone.

7. Procédé selon la revendication 6 lorsqu'elle est rattachée à la revendication 2, l'implantation ionique étant effectuée selon une dose permettant de conférer à la phase gazeuse constituée dans ladite zone une pression suffisante pour déformer au moins l'un (22, 32) des deux éléments de la structure (20, 30).

8. Procédé selon la revendication 7, la forme de ladite zone implantée étant telle que la déformation dudit élément (22, 32) de la structure (20, 30) constitue un bossage ou un coussinet (24, 33).

9. Procédé selon l'une des revendications 7 ou 8, la face externe de l'élément (32) déformé par la pression de la phase gazeuse étant rendue conductrice, la structure (30) pouvant ainsi présenter un contact électrique souple à un élément extérieur (35).

10. Procédé selon l'une des revendications 7 ou 8, comportant la formation d'électrodes (23, 25) positionnées de façon à former au moins un condensateur où ladite phase gazeuse intervient comme diélectrique.

11. Utilisation du procédé selon la revendication 10 pour obtenir un capteur de pression par mesure de la capacité dudit condensateur.

12. Utilisation du procédé selon la revendication 10 pour obtenir une matrice de capteurs de pression par mesure des capacités correspondant aux condensateurs formés à partir d'une matrice de zones implantées.

13. Utilisation du procédé selon la revendication 5 pour obtenir une masse de SiC recouverte d'une couche de SiO₂, ladite structure (50) étant constituée d'un premier élément (51) en silicium et d'un deuxième élément (52) en SiO₂ obtenu par croissance thermique à partir du premier élément (51), le deuxième élément (52) étant solidarisé à la masse de SiC (40) avant de provoquer la séparation entre le premier et le deuxième élément.

## Claims

1. Method of separation of at least two elements (11, 12; 21, 22; 31,32) of different types, of a structure, the two elements being in contact with one another along an interface (13, 27, 36) fixed to one another by interatomic bonds at said interface, comprising performing an ion implantation in order to introduce ions into the structure (10, 20, 30) with an adequate energy for them to reach said interface (13, 27, 36) and with an adequate dose to break said interatomic bonds and permit a separation of the two elements (11, 12; 21, 22; 31, 32).

2. Method of separation according to claim 1, wherein the implanted ion dose brings about, at said interface, the formation of a gaseous phase having an adequate pressure to permit the separation of the two elements.

3. Method of separation according to claim 1 or 2, the implantation step being followed by a heat treatment step permitting the concentration of the implanted ions at said interface (13, 27, 36).

4. Method of separation according to any claims of 1 to 3, wherein, said structure (10, 20, 30) being a semiconductor structure of the silicon on insulator type, a silicon layer (12, 21, 31) constituting one of the two elements of the structure and a silicon oxide layer (11, 22, 32) constituting the other element of the structure, the implanted ions are hydrogen ions.

5. Method according to any of claims 1 to 4, wherein ion implantation takes place on the entire interface (13), so as to obtain a complete separation of the two elements (11, 12) of the structure (10).

6. Method according to any of claims 1 to 4, wherein ion implantation takes place on at least one area of said interface (27, 36), so as to obtain a separation of the two elements (21, 22 ; 31, 32) of the structure (20, 30) jin said area.

7. Method according to claim 6 when dependent on claim 2, wherein ion implantation takes place at a dose making it possible to give the gaseous phase formed in said area an adequate pressure to deform at least one (22, 32) of the two elements of the structure (20, 30).

8. Method according to claim 7, wherein the shape of said implanted area is such that the deformation of said element (22, 32) of the structure (20, 30) constitutes a boss or cushion (24, 33).

9. Method according to claim 7 or 8, wherein the external face of the element (32) deformed by the pressure of the gaseous phase is made conductive, so that the structure (30) can consequently have a flexible electrical contact with an external element (35).

10. Method according to claim 7 or 8, wherein there is a formation of electrodes (23, 25) positioned so as to form at least ore capacitor, where said gaseous phase acts as a dielectric.

11. Use of the method according to claim 10 to obtain a pressure sensor by measuring the capacitance of said capacitor.

12. Use of the method according to claim 10 to obtain an array of pressure sensors by measuring the capacitances corresponding to the capacitors formed from an array of implanted areas.

13. Use of the method according to claim 5 to obtain a SiC mass covered with a SiO₂ layer, said structure (50) being constituted by a first element (51) made of silicon and a second element (52) made of SiO₂ obtained by thermal growth from the first element (51), the second element (52) being joined to the SiC mass (40) before bringing about the separation between the first and second elements.

## Patentansprüche

1. Verfahren zum Trennen von wenigstens zwei Elementen (11, 12 ; 21, 22 ; 31, 32) unterschiedlicher Arten einer Struktur, wobei die beiden Elemente gemäß einer Grenzfläche (13, 27, 36) miteinander Kontakt haben und durch interatomare Bindungen in Höhe dieser Grenzfläche aneinander befestigt sind, umfassend:
eine lonenimplantation, um Ionen in die Struktur (10, 20, 30) einzutragen, mit einer ausreichenden Energie, um die genannte Grenzfläche (13, 27, 36) zu erreichen, und
entsprechend einer Dosis, die ausreicht, die interatomaren Bindungen zu brechen und eine Trennung der beiden Elemente (11, 12 ; 21, 22 ; 31, 32) zu ermöglichen.

2. Trennverfahren nach Anspruch 1, wobei die Dosis implantierter Ionen in Höhe der genannten Grenzfläche die Bildung einer gasförmige Phase mit einen Druck besitzt, der ausreicht, die Trennung der beiden Elemente zu ermöglichen.

3. Trennverfahren nach einem der Ansprüche 1 oder 2, wobei der lonenimplantationsschritt, gefolgt von einem Wärmebehandlungsschritt, ermöglicht, die implantierten Ionen in Höhe der genannten Grenzfläche (13, 27, 36) zu konzentrieren.

4. Trennverfahren nach einem der Ansprüche 1 bis 3, wobei die genannte Struktur (10, 20, 30) eine Halbleiterstruktur des SOI-Typs ist, eine Siliciumschicht (12, 21, 31) eines der beiden Elemente der Struktur bildet, eine Siliciumoxidschicht (11, 22, 32) das andere Element der Struktur bildet und die implantierten Ionen Wasserstoff-lonen sind.

5. Verfahren nach einem der Ansprüche 1 bis 4, wobei die Ionenimplantation über die Gesamtheit der genannten Grenzfläche (13) erfolgt, um eine vollständige Trennung der beiden Elemente (11, 12) der Struktur (10) zu erhalten.

6. Verfahren nach einem der Ansprüche 1 bis 4, wobei die lonenimplantation über wenigstens eine Zone der genannten Grenzfläche (27, 36) erfolgt, um eine Trennung der beiden Elemente (21, 22 ; 31, 32) der Struktur (20, 30) in dieser Zone zu erhalten.

7. Verfahren nach Anspruch 6 in Verbindung mit Anspruch 2, wobei die Ionenimplantation einer Dosis entspricht, die ermöglicht, der in der genannten Zone gebildeten gasförmige Phase einen Druck zu verleihen, der ausreicht, wenigstens eines (22, 32) der beiden Elemente der Struktur (20, 30) zu verformen.

8. Verfahren nach Anspruch 7, wobei die Form der genannten implantierten Zone so ist, dass die Verformung des genannten Elements (22, 32) der Struktur (20, 30) einen Buckel oder ein Kissen (24, 33) bildet.

9. Verfahren nach einem der Ansprüche 7 oder 8, wobei die Außenseite des durch den Druck der gasförmige Phase verformten Elements (32) leitfähig gemacht wird und die Struktur (30) so einen nachgiebigen Kontakt mit einem äußeren Element (35) haben kann.

10. Verfahren nach einem der Ansprüche 7 oder 8, die Bildung von Elektroden (23, 25) umfassend, die so positioniert sind, dass sie wenigstens einen Kondensator bilden, bei dem die gasförmige Phase als Dielektrikum fungiert.

11. Anwendung des Verfahrens nach Anspruch 10, um durch Messung der Kapazität des genannten Kondensators einen Drucksensor zu erhalten.

12. Anwendung des Verfahrens nach Anspruch 10, um eine Matrix von auf Kapazitätsmessung basierenden Drucksensoren herzustellen, entsprechend den aufgrund einer Matrix implantierter Zonen gebildeten Kondensatoren.

13. Anwendung des Verfahrens nach Anspruch 5, um eine mit einer SiO₂-Schicht überzogene SiC-Masse zu erhalten, wobei die genannte Struktur (50) gebildet wird durch ein erstes Element (51) aus Silicium und ein zweites Element (52) aus SiO₂, realisiert durch thermisches Wachstum auf dem ersten Element (51), wobei das zweite Element (52) mit der SiC-Masse (40) verbunden wird, bevor man die Trennung zwischen dem ersten und dem zweiten Element herbeiführt.
